# EUROPEAN PATENT SPECIFICATION

(11) **EP 0 835 917 B1**
(45) Date of publication and mention of the grant of the patent: **30.08.2006**
(21) Application number: 97919689.6
(22) Date of filing: 24.04.1997
(51) Int. Cl.: C09J 175/14, C09J 163/10, G11B 7/24

(54) **ULTRAVIOLET-CURING ADHESIVE COMPOSITION AND ARTICLE**
UV-HÄRTBARE KLEBSTOFFZUSAMMENSETZUNG UND GEGENSTAND
COMPOSITION ADHESIVE A SECHAGE AUX U.V. ET ARTICLE CORRESPONDANT

(30) Priority: 25.04.1996 WO PCT/JP96/01134; 21.06.1996 JP 17987096
(43) Date of publication of application: 15.04.1998
(73) Proprietor: NIPPON KAYAKU KABUSHIKI KAISHA, Tokyo 102-0071 (JP)
(72) Inventor: TOKUDA, Kiyohisa, Saitama 336 (JP); YOSHIDA, Kenji, Saitama 338 (JP); ISHII, Kazuhiko, Saitama 350-11 (JP); YOKOSHIMA, Minoru, Ibaraki 302 (JP)
(74) Representative: Gille Hrabal Struck Neidlein Prop Roos
(86) International application number: PCT/JP1997/001445
(87) International publication number: WO 1997/040115

(56) References cited:
- EP-A- 0 395 369
- JP-A- 2 003 132
- JP-A- 3 033 173
- JP-A- 5 125 330
- JP-A- 8 127 760
- JP-A- 9 031 416
- JP-A- 63 284 213
- JP-B- 4 025 614
- US-A- 5 356 949
- DATABASE WPI Week 9227 Derwent Publications Ltd., London, GB; AN 92-223594 XP002059445 & JP 04 149 443 A (MITSUBISHI ELECTRIC CORP. RYODEN KASEI KK) , 22 May 1992
- DATABASE WPI Week 9332 Derwent Publications Ltd., London, GB; AN 93-254563 XP002059446 & JP 05 175 332 A (DIAFOIL HOECHST KK) , 13 July 1993
- CHEMICAL ABSTRACTS, vol. 108, no. 2, 11 January 1988 Columbus, Ohio, US; abstract no. 7171p, XP002059444 & JP 62 124 172 A (ISONO, KENOSUKE ET AL) 5 June 1987
- CHEMICAL ABSTRACTS, vol. 117, no. 24, 14 December 1992 Columbus, Ohio, US; abstract no. 235100f, XP000351339 & JP 04 159 317 A (KAWASAKI, MINORU) 2 June 1992
- DATABASE WPI Week 9417 Derwent Publications Ltd., London, GB; AN 94-141483 XP002059447 & JP 06 089 462 A (TOKYO THREE BOND CO LTD) , 29 March 1994

## Description

### TECHNICAL FIELD

This invention relates to an ultraviolet-curable adhesive composition, particularly to an adhesive composition for a lamination type optical disc which can be cured with an ultraviolet ray in the mutual bonding of (1) a substrate having a translucent film of an inorganic type such as gold, silver, silicon, or a silicon compound (referred to hereinafter as the translucent film), (2) a substrate having a metal-sputter film (referred to hereinafter as the metal sputter) of aluminum and (3) a resin substrate of a polycarbonate type, a polyacrylate type, or a polyvinyl type and can maintain a sufficient bonding strength to the above three substrates (1) to (3).

### BACKGROUND ART

In a single sided read system laminate type optical disc, a representative of which is a laminate type optical disc (referred to hereinafter as the laminate optical disc in some cases) such as DVD (digital video disc or digital versatile disc), it has heretofore been sufficient to bond (3) a resin substrate of a polycarbonate to (2) a metal-sputter substrate. However, as to the laminate optical disc required to have a higher recording density, it has become an important technique to use a sheet of disc in the form of multilayer laminate. For recording information over the multilayer, it is necessary to additionally form, in addition to a conventional reflective film layer such as the metal sputter, a layer composed of gold, silicon, or a silicon compound having functions of a reflecting layer and a light transmittable layer as a translucent film layer. That is to say, in a recent single sided read system multilayer type laminate optical disc, a representative of which is DVD-9 or DVD-18, it has been desired that the translucent film substrate (1) as well as the polycarbonate resin substrate and the metal-sputter substrate is also sufficiently laminated and bonded.

In bonding a film of gold, silver, silicon, a silicon compound , the interface is inactive as compared with other inorganic matters, so that it has heretofore been considered to be difficult to impart chemical and physical actions effective to the bonding. As a result, the present situation is that no adhesive which is sufficiently satisfactory in performance and productivity has been provided for such reasons as no sufficient bonding strength being obtained in the bonding, or a primer treatment being required.

With the conventional bonding method or adhesive, there are problems in respect of productivity in the optical disc lamination such as no sufficient bonding strength being obtained particularly as to the translucent film substrate (1) among the above-mentioned three substrates, or a pretreatment such as a primer being required, and the solution thereof has been desired.

Document JP -A- 5-125330 describes adhesives comprising (meth) acrylate components and a light-sensitive polymerization initiation system consisting of a diketone together with a sensitizer which is structurally similar to Michler's ketone. It is typical of this adhesive composition that it is highly sensitive to light, which it less suitable for use in transparent materials and has the further problem of leading to a lack of sufficient pot-life.

### DISCLOSURE OF INVENTION

The present inventors have eagerly made research for solving the above-mentioned problems and have consequently found that when (A) a bisphenol type epoxy (meth)acrylate having a molecular weight of 450 to 3,000, (B) a urethane (meth)acrylate having a molecular weight of 400 to 10,000 and (E) a (meth)acrylate monomer other than (A) and (B), and (F) a photopolymerization initiator are used, an ultraviolet-curable adhesive which can bond inactive substrates with a sufficient bonding strength, and have completed this invention.

That is to say, this invention relates to:
(1) an ultraviolet-curable adhesive composition which comprises (A) a bisphenol type epoxy (meth)acrylate having a molecular weight of 450 to 3,000, (B) a urethane(meth)acrylate having a molecular weight of 400 to 10,000, (E) a (meth)acrylate monomer other than (A) and (B), and (F)- one or more photopolymerization initiator(s) selected from the group consisting of 1-hydroxycyclohexyl phenyl ketone, (1-6-η-cumene) (η-cyclopenta-dienyl)iron (1+) hexafluorophosphoric acid (1-), 2,2-dimethoxy-2-phenylacetophenone, 2-methyl-[4-(methylthio)-phenyl]-2-morpholino-1-propanone, 2-chlorothioxanthone, 2,4-dimethylthioxanthone, 2,4-diethylthioxanthone, 2,4-diisopropyl-thioxanthone, isopropylthioxanthone, 2,4,6-trimethylbenzoyldiphenylphosphine oxide and bis(2,6-dimethoxybenzoyl)-2,4,4-trimethylpentylphosphine oxide;
(2) the ultraviolet-curable adhesive composition of (1) above, wherein the urethane (meth)acrylate (B) has a polyester structure, a polyether structure or a polycarbonate structure;
(3) the ultraviolet-curable adhesive composition of (1) above, which comprises (C) a (meth)acrylate monomer having a cyclic structure as the (meth)acrylate monomer (E) other than (A) and (B);
(4) the ultraviolet-curable adhesive composition of (1) above, which comprises (C) a (meth)acrylate monomer having a cyclic structure and (D) an aliphatic (meth)acrylate monomer having a hydroxyl group as the (meth)acrylate monomer (E) other than (A) and (B);
(5) the ultraviolet-curable adhesive composition of (1) above, wherein as the nonvolatile matter in the ultraviolet-curable adhesive, the bisphenol type epoxy (meth) acrylate (A) having a molecular weight of 450 to 3,000 is contained 5 to 70% by weight, the urethane (meth)acrylate (B) having a molecular weight of 400 to 10,000 is contained 5 to 60% by weight, the (meth)acrylate monomer (E) other than (A) and (B) is contained 10 to 80% by weight, and the photopoly-merization initiator (F) is contained 0.01 to 20% by weight;
(6) the ultraviolet-curable adhesive composition of (5) above, wherein the (meth)acrylate monomer (E) other than (A) and (B) is composed of 100 to 30% by weight of (C) a (meth)acrylate monomer having a cyclic structure, 0 to 70% by weight of (D) an aliphatic (meth)acrylate monomer having a hydroxyl group and 0 to 20% by weight of a (meth)acrylate monomer other than (C) and (D);
(7) the ultraviolet-curable adhesive composition of (5) above, wherein the (meth)acrylate monomer (E) other than (A) and (B) is composed of 95 to 30% by weight of (C) a (meth)acrylate monomer having a cyclic structure, 5 to 70% by weight of (D) an aliphatic (meth)acrylate monomer having a hydroxyl group and 0 to 20% by weight of a (meth)acrylate monomer other than (C) and (D);
(8) an article having a layer composed of a cured product of the ultraviolet-curable adhesive composition of any one of (1) to (7);
(9) the article of (8) above which is an optical disc;
(10) the article of (9) above, wherein the optical disc is DVD; and
(11) the article of (10) above, wherein the DVD is a single sided read system double layer type DVD.

### BEST MODE FOR CARRYING OUT THE INVENTION

The ultraviolet-curable adhesive composition of this invention comprises, as the essential components, (A) a bisphenol type epoxy (meth)acrylate having a molecular weight of 450 to 3,000, (B) a urethane (meth)acrylate having a molecular weight of 400 to 10,000, (E) a (meth)acrylate monomer other than (A) and (B), and (F) a photopolymerization initiator and can, if necessary, contain (G) a (meth)acrylate oligomer other than the above and (H) components such as a high molecular weight polymer, a solvent, various additives. In the ultraviolet-curable adhesive composition of this invention, the presence of the component (A) and the component (B) allows the basic properties as an ultraviolet-curable adhesive to be exerted and the presence of the component (E) further enhances the basic properties.

The bisphenol type epoxy (meth)acrylate (A) having a molecular weight of 450 to 3,000 used in this invention is an epoxy (meth)acrylate obtained by the reaction of a bisphenol type epoxy resin with (meth)acrylic acid or a hydroxy(meth)acrylate. As the bisphenol type epoxy resin, there are mentioned, for example, bisphenol A type epoxy resins such as Epikote 828, Epikote 1001, and Epikote 1004 (these are all trade names of Yuka-Shell Epoxy Co., Ltd.); bisphenol F type epoxy resins such as Epikote 4001P, Epikote 4002P, Epikote 4003P (these are all trade names of Yuka-Shell Epoxy Co., Ltd.). As preferable bisphenol type epoxy (meth)acrylates (A), there are mentioned bisphenol A type epoxy resins.

The urethane (meth)acrylate (B) having a molecular weight of 400 to 10,000 used in this invention is obtained by the reaction of an organic polyisocyanate with a hydroxy(meth)acrylate compound or the reaction of a polyol with an organic polyisocyanate and a hydroxy(meth)acrylate compound.

As the polyol, there are mentioned polyether polyols such as polypropylene glycol, polytetramethylene glycol polyester polyols obtained by the reaction of a polyhydric alcohol (as mentioned hereinafter) with a polybasic acid (for example, succinic acid, phthalic acid, hexahydrophthalic anhydride, terephthalic acid, adipic acid, azelaic acid, tetrahydrophthalic anhydride); caprolactone polyols obtained by the reaction of a polyhydric alcohol (as mentioned hereinafter) with the above-mentioned polybasic acid and ε-caprolactone or the reaction of a polyhydric alcohol (as mentioned hereinafter) with ε-caprolactone; polycarbonate polyols (for example, a polycarbonate polyol obtained by the reaction of 1,6-hexanediol with a diphenyl carbonate. Also, as the organic polyisocyanate, there are mentioned, for example, isophorone diisocyanate, hexamethylene diisocyanate, tolylene diisocyanate, xylene diisocyanate, diphenylmethane-4,4'-diisocyanate, and dicyclopentanyl diisocyanate. Particularly preferable components (B) are urethane (meth)acrylates having a polyester structure, a polyether structure or a polycarbonate structure obtained using, as the polyol, a polyester polyol, a polyether polyol, a polycaprolactone polyol, and a polycarbonate polyol.

As the above polyhydric alcohol, there are mentioned, for example, neopentyl glycol, ethylene glycol, diethylene glycol, propylene glycol, 1,6-hexanediol, 1,4-butanediol, trimethylolpropane, pentaerythritol, tricyclodecanedimethylol, and bis(hydroxymethyl)cyclohexane

As the (meth)acrylate monomer (E) other than (A) and (B) used in this invention, there are preferred (C) (meth)acrylate monomers having a cyclic structure, for example, an aliphatic ring, an aromatic ring, or a heterocyclic ring and/or (D) aliphatic (meth)acrylate monomers having a hydroxyl group are preferred.

As the (meth)acrylate monomer component (C) having a cyclic structure, there are mentioned, for example, monomers having at least one (meth)acryloyl group in the molecule such as tricyclodecane (meth)acrylate, dicyclopentanyl (meth)acrylate, isobornyl (meth)acrylate, adamantyl (meth)acrylate, phenyl (meth)acrylate, benzyl (meth)acrylate, tetrahydrofurfuryl (meth)acrylate, morpholine acrylate, phenylglycidyl (meth) acrylate; polyfunctional monomers having at least two (meth)acryloyl groups in the molecule such as tris[(meth)-acryloxyethyl] isocyanurate, caprolactone-modified tris[(meth)acryloxyethyl] isocyanurate, dicyclopentanyl di(meth)acrylate, tricyclodecanedimethylol di(meth)-acrylate, hydropivalylaldehyde trimethylolpropane di(meth)acrylate. Also, the monomer having at least one (meth)acryloyl group in the molecule includes the above-mentioned monomer components (C) modified with an alkylene oxide, which is preferably used. In particular, those modified with an alkylene oxide having 2 to 3 carbon atoms are preferable, and there are mentioned, for example, dicyclopentadieneoxyethyl (meth) acrylate, phenyloxyethyl (meth) acrylate.

As the aliphatic acrylate (D) having a hydroxyl group, particularly preferable are acrylate compounds having an aliphatic group having 2 to 9 carbon atoms, and furthermore, acrylate compounds having an aliphatic group having 2 to 4 carbon atoms are more preferable. There are mentioned monomers having one (meth)acryloyl group in the molecule such as 2-hydroxyethyl (meth)acrylate, 2-hydroxypropyl (meth)acrylate, 4-hydroxybutyl (meth)acrylate, 2-hydroxy-3-phenoxypropyl (meth)acrylate, ethylene oxide-modified phosphoric acid di(meth)acrylate, N-methylolacrylamide and the like; and polyfunctional monomers having at least two (meth)acryloyl groups in the molecule such as pentaerythritol tri(meth)acrylate, glycerol di(meth)acrylate, triglycerol di(meth)acrylate, epichlorohydrin-modified phthalic acid di(meth)acrylate, epichlorohydrin-modified 1,6-hexanediol di(meth)acrylate, epichlorohydrin-modified propylene glycol di(meth)acrylate, epichlorohydrin-modified ethylene glycol di(meth)acrylate, epichlorohydrin-modified glycerol tri (meth) acrylate, epichlorohydrin-modified trimethylolpropane tri(meth)acrylate, ethylene oxide-modified phosphoric acid di (meth) acrylate.

As the (meth)acrylate monomer (E) other than the above-mentioned (C) and (D), there are mentioned monofunctional acrylate compounds, for example, 2-methoxyethyl (meth)acrylate, 3-methoxybutyl (meth)acrylate, methoxytriethylene glycol (meth)acrylate, butoxyethyl (meth)acrylate, methoxydipropylene glycol (meth)acrylate, diacetone (meth)acrylamide, N-n-butoxymethyl (meth)acrylamide difunctional (meth)acrylate compounds of aliphatic diols having 4 to 9 carbon atoms, for example, neopentyl glycol di(meth)acrylate, 1,6-hexanediol di(meth)acrylate ; or modified compounds thereof which are difunctional (meth)acrylate compounds of polyether type polyols having 8 to 46 carbon atoms, for example, neopentyl glycol hydroxypivalic acid di(meth)acrylate, neopentyl glycol-modified trimethylolpropane di(meth)acrylate, polyethylene glycol di (meth)-acrylate, tripropylene glycol di(meth)acrylate; trifunctional or more functional (meth)acrylate compounds, for example, trimethylolpropane tri(meth) acrylate, pentaerythritol tri(meth)acrylate, C₂-C₅ aliphatic hydrocarbon-modified trimethylolpropane tri (meth) acrylates, C₂-C₅ aliphatic hydrocarbon-modified dipentaerythritol penta(meth)acrylates, C₂-C₅ aliphatic hydrocarbon-modified dipentaerythritol tetra(meth)-acrylates, dipentaerythritol hexa(meth)acrylate, caprolactone-modified dipentaerythritol hexa(meth)acrylate, pentaerythritol tetra(meth)acrylate, ditrimethylolpropane tetra (meth) acrylate.

The (meth)acrylate monomer (E) other than (A) and (B) is used mainly for further improving the adhesiveness. For example, for improving the adhesiveness to a plastic product such as a substrate for an optical disc or the like, it is preferable to use the (meth)acrylate monomer (C) having a cyclic structure, and for improving the adhesiveness to the translucent film or metal, it is preferable to use the aliphatic (meth)acrylate monomer (D) having a hydroxyl group. Furthermore, it is preferable to use, if necessary, a (meth)acrylate monomer other than (C) and (D).

As to the proportions of these components used, the (meth)acrylate monomer (C) having a cyclic structure is preferably about 100 to 30% by weight, more preferably 100 to 50% by weight, and further preferably about 100 to 65% by weight; the aliphatic (meth)acrylate monomer (D) having a hydroxyl group is preferably about 0 to 70% by weight, more preferably about 0 to 50% by weight, and further preferably about 0 to 35% by weight; and the (meth)acrylate monomer other than (C) and (D) is preferably about 0 to 20% by weight, more preferably about 0 to 15% by weight, and further preferably about 0 to 10% by weight.

Incidentally, when the aliphatic (meth)acrylate monomer (D) having a hydroxyl group is used as an essential component, the proportion of the same used is preferably about 5 to 70% by weight, more preferably about 10 to 50% by weight, and further preferably about 15 to 35% by weight, and the proportion of the component (C) used and the proportion of the (meth)acrylate monomer other than (C) and (D) used are the same as mentioned above.

As the (meth)acrylate monomer (G) which may be used in addition to the above [referred to hereinafter as the oligomer component (G) in some cases], there are mentioned polyester (meth)acrylates obtained by the reaction of polyester polyols with (meth)acrylic acid,

The polyester polyol is obtained by the reaction of a polyhydric alcohol with a polybasic acid. As the polyhydric alcohol, there are mentioned, for example, neopentyl glycol, ethylene glycol, propylene glycol, 1,6-hexanediol, trimethylolpropane, pentaerythritol, tricyclodecanedimethylol, bis (hydroxymethyl) cyclohexane

As the polybasic acid, there are mentioned, for example, succinic acid, phthalic acid, hexahydrophthalic anhydride, terephthalic acid, adipic acid, azelaic acid, tetrahydrophthalic anhydride. This oligomer component (G) is used, for example, when it is necessary to adjust the viscosity of a resin solution and improve the flexibility after the curing.

The photopolymerization initiator (F) used in this invention is selected from 1-hydroxycyclohexyl phenyl ketone, (1-6-η-cumene) (η-cyclopentadienyl) iron(1+) hexafluorophosphoric acid (1-), 2,2-dimethoxy-2-phenylacetophenone, 2-methyl-[4-(methylthio) phenyl] -2-morpholino-1-propanone, 2-chlorothioxanthone, 2,4-dimethylthioxanthone, 2,4-diethylthioxanthone, 2,4-diisopropylthioxanthone, isopropylthioxanthone, 2,4,6-trimethylbenzoyldiphenylphosphine oxide, and bis(2,6-dimethoxybenzoyl)-2,4,4-trimethylpentylphosphine oxide As particularly preferable photopolymerization initiators, there are mentioned compounds having an absorption wave length of not less than 360 nm but not more than 450 nm and a molar extinction coefficient of not less than 400, for example 2-chlorothioxanthone, 2,4-dimethylthioxanthone, 2,4-diisopropylthioxanthone, isopropylthioxanthone, 2,4,6-trimethylbenzoyldiphenylphosphine oxide, and bis (2, 6-dimethoxybenzoyl)-2,4,4-trimethylpentylphosphine oxide These photopolymerization initiators may be used alone or in admixture of two or more in any proportion.

The above-mentioned components are used as the nonvolatile matter in the ultraviolet-curable adhesive composition of this invention so that the bisphenol A type epoxy (meth)acrylate (A) having a molecular weight of 450 to 3,000 is contained preferably about 5 to 70% by weight, more preferably about 10 to 50% by weight, and further preferably about 10 to 30% by weight; the urethane (meth)acrylate (B) having a molecular weight of 400 to 10,000 is contained preferably about 5 to 60% by weight, more preferably about 20 to 60% by weight, and further preferably about 30 to 50% by weight; the (meth)acrylate monomer (E) other than (A) and (B) is contained preferably about 10 to 80% by weight, more preferably about 20 to 70% by weight, and further preferably about 30 to 50% by weight; the photopolymerization initiator (F) is contained preferably about 0.01 to 20% by weight, more preferably about 1 to 15% by weight, and further preferably about 3 to 10% by weight, and the (meth)acrylate oligomer (G) other than the above is contained preferably about 0 to 30% by weight, more preferably about 0 to 20% by weight, and further preferably about 0 to 10% by weight.

In this invention, if necessary, a photopolymerization initiating coagent such as an amine or the like can be used. As the photopolymerization initiating coagent, there are mentioned, for example, 2-dimethylaminoethyl benzoate, dimethylaminoacetophenone, ethyl p-dimethylaminobenzoate, isoamyl p-dimethylaminobenzoate, and the like. The amount of the photopolymerization initiating coagent used is usually preferably 0 to 15% by weight, further preferably about 0 to 10% by weight, based on the components obtained by removing volatile matters such as solvent and the like from the composition.

Moreover, in this invention, if necessary, for component (H) such components as a high molecular weight polymer, an organic solvent, various additives and the like can be used. As the high molecular weight polymer, there can be used, for example, polyester type resins, polycarbonate type resins, polyacrylate type resins, polyurethane type resins, or polyvinyl type resins As the organic solvent, there are mentioned toluene, xylene, methyl ethyl ketone, isopropanol, diethylene glycol monoethyl ether acetate, diethylene glycol monobutyl ether, diethylene glycol monobutyl ether acetate, diethylene glycol mono-, or di-ethyl ether. As the various additives, there are mentioned, for example, silane-coupling agent, polymerization inhibitor, leveling agent, surface lubricant, defoaming agent, light stabilizer, antioxidant, antistatic agent, or filler. As the silane-coupling agent, there are mentioned alkyl type, amine type, (meth)acrylate type, isocyanate type, epoxy type, or thiol type. As the polymerization inhibitor, there are mentioned metoquinone, and methylhydroquinone. As the leveling agent, surface lubricant and defoaming agent, there are mentioned organic polymer type, silicon type, and fluorine type As the antioxidant, there are mentioned hindered amine type, hindered phenol type, and high molecular weight phenol type . As the antistatic agent, there are mentioned quaternary ammonium salt type, polyether type, and electroconductive powder. As the filler, there are mentioned silica gel, titanium oxide, alumina, and electroconductive powder. These components are used, for example, when it is necessary to adjust the viscosity of a resin solution and improve the flexibility after the curing.

The adhesive composition of this invention can be obtained by mixing and dissolving the above-mentioned components at room temperature to 80°C using an organic solvent or without using an organic solvent. The cured product of the composition of this invention can be obtained by irradiation with a ray such as an ultraviolet ray, or a visible light laser in the conventional manner. The curing of the adhesive composition of this invention by irradiation with a ray such as an ultraviolet ray is specifically conducted by irradiation with an ultraviolet ray using a low pressure or high pressure mercury lamp, a metal halide lamp, a xenone lamp

The adhesive composition of this invention is useful as an adhesive for bonding the metal-sputter surface of the metal-sputter-treated substrate (2) as one adherent to the translucent film surface of the translucent film-treated substrate (1) or the surface of the resin substrate (3) of a polycarbonate as the other adherent. Moreover, it is also useful as an adhesive for bonding the translucent film surfaces of the translucent film-treated substrate (1) to each other, the metal-sputter surfaces of the metal-sputter-treated substrate (2) to each other or the resin substrates (3) of a polycarbonate to each other. The materials of the above substrates (1) to (3) are not particularly limited in shape of substrate as far as they are substrates based on a resin, for example, a polyvinyl type resin, a polycarbonate type resin, a polyacrylate type resin, an amorphous polyolefin type, and, for example, either plate-like substrate or film-like substrate can be applied.

The article of this invention has a layer composed of a cured product of the above-mentioned ultraviolet-curable adhesive composition, and examples thereof include optical disc, IC card, ID card, and optical card. A more preferable article is DVD, particularly the laminate optical disc, a representative of which is a single sided read system double layer type DVD.

The article of this invention can be obtained, for example, by coating or placing a given amount of the ultraviolet-curable adhesive composition of this invention on any one of the above substrates (1) to (3) or, particularly in the case of a single sided read system double layer type DVD, on either the metal-sputter surface of the metal-sputter-treated substrate (2) or the translucent film surface of the translucent film-treated substrate (1), thereafter sandwiching the ultraviolet-curable adhesive in between the above substrate and another substrate with its metal-sputter surface or translucent film surface inside and irradiating the assembly with an ultraviolet ray from above either of the substrates to cure the ultraviolet-curable adhesive of this invention, thereby bonding the substrates to each other. In the case of a double sided read system DVD, it is sufficient to coat or place a given amount of the ultraviolet-curable adhesive of this invention on the metal-sputter surface of the metal-sputter-treated substrate (2) and thereafter sandwich the ultraviolet-curable adhesive in between the above substrate and the metal-sputter surface of another metal-sputter-treated substrate (2) and then bond the substrates to each other in the same manner as above. In these methods, if necessary, the curing can be effected with a visible light laser in place of the ultraviolet ray. As a coating means, there are mentioned a roll coater, a spin coater, a means for a 2P method, and a screen printer Incidentally, the 2P method means a method in which an adhesive is dropped onto one of the substrates and the other substrate to be bonded is pressed to bond them.

The film thickness of the cured layer is preferably 1 to 200 µm, more preferably 10 to 150 µm, and further preferably about 30 to 100 µm. Incidentally, it is needless to say that even when the metal-sputter surface of the metal-sputter-treated substrate (2) is bonded to a substrate which has not been subjected to translucent or opaque treatment, this invention can be applied.

Incidentally, the single sided read system double layer type DVD utilizes the properties of a translucent film layer that it transmits or reflects a laser depending upon the focus of light pickup and is called DVD-9 (an article formed by laminating two sheets thereof is called DVD-18), and usually used as ROM (read only memory). This is obtained by bonding a DVD substrate in which the information-writing surface of an information-written transparent substrate (made of, for example, a polycarbonate) has been subjected to metal-sputter-treatment to another DVD substrate in which a translucent film layer has been provided on the information-writing surface of a transparent substrate (made of, for example, a polycarbonate) to which information has been written similarly, in such a manner that the metal-sputter-treated surface and the translucent layer surface face each other. As the metal of the metal sputter, for example, aluminum is mentioned, and as the translucent film, there are mentioned thin films of, for example, gold, silver, silicons, and a silicon compound.

This invention is more specifically explained below by Examples. Incidentally, the term "part" in the Examples means part by weight.

### Examples 1 to 5 and Comparative Examples 1 to 4

Among the components shown in Table 1, the resin components were dissolved with stirring at 60°C in one hour. Thereafter, the photopolymerization initiator and others were added to prepare ultraviolet-curable adhesive compositions for Examples 1 to 5 and Comparative Examples 1 to 4. Each of the compositions obtained was coated on the adhesive surface of one of the substrates [the translucent film surface of a polycarbonate substrate (1) treated with a gold film as a translucent film, the metal-sputter surface of a polycarbonate substrate (2) sputter-treated with aluminum as a metal or the surface of a polycarbonate resin substrate (3)] in a coating thickness of about 50 µm, this coated surface was intimately contacted with the adhesive surface of the other substrate [the translucent film surface of (1), the metal-sputter surface of (2) or the resin substrate surface of (3)], and the composition was cured in a curing apparatus provided with a high pressure mercury lamp (80 w/cm) to bond the substrates to each other. Thereafter, the substrates bonded were peeled and the surface state thereof was observed. The results of the observation are shown in Table 1.

Incidentally, the abbreviation of each composition shown in the Table is as mentioned below. Incidentally, the numerical values in the Table are parts by weight.
- EPA-1:: Bisphenol A type epoxy acrylate manufactured by NIPPON KAYAKU CO., LTD.
- UX-2301:: Polyether type urethane acrylate manufactured by NIPPON KAYAKU CO., LTD.
- UX-4101:: Polyester type urethane acrylate manufactured by NIPPON KAYAKU CO., LTD.
- M-1200:: Polyester type urethane acrylate manufactured by TOAGOSEI CHEMICAL INDUSTRY CO., LTD.
- M-315:: Tris(acryloxyethyl) isocyanurate manufactured by TOAGOSEI CHEMICAL INDUSTRY CO., LTD.
- MANDA:: Hydropivalic acid neopentyl glycol diacrylate manufactured by NIPPON KAYAKU CO., LTD.
- HDDA:: 1,6-Hexanediol diacrylate manufactured by NIPPON KAYAKU CO., LTD.
- R-561:: Phenyloxyethyl acrylate manufactured by NIPPON KAYAKU CO., LTD.

- FA-513A:: Tricyclodecane acrylate manufactured by Hitachi Chemical Co., Ltd.
- TC-101:: Tetrahydrofurfuryl acrylate manufactured by NIPPON KAYAKU CO., LTD.
- HO:: 2-Hydroxyethyl methacrylate manufactured by Kyoeisha Kagaku K. K.
- PM-2:: Bis(2-methacryloyloxyethyl) phosphate manufactured by NIPPON KAYAKU CO., LTD.
- DETX:: 2,4-Diethylthioxanthone, a photopolymerization initiator manufactured by NIPPON KAYAKU CO., LTD.
- Irg-184:: 1-Hydroxycyclohexyl phenyl ketone, a photopolymerization initiator manufactured by CIBA GEIGY Corp.
- Irg-1800:: Mixture of Irg-184 with bis(2,6-dimethoxybenzoyl)-2,4,4-trimethylpentylphosphine oxide, a photopolymerization initiator manufactured by CIBA GEIGY Corp.
- TPO:: 2,4,6-Trimethylbenzoyldiphenylphosphine oxide, a photopolymerization initiator manufactured by BASF
- DMBI:: Isoamyl p-dimethylaminobenzoate, a photopolymerization initiating coagent manufactured by NIPPON KAYAKU CO., LTD.

**Table 1**

| Resin | | | Example | | | | Comparative Example | | | |
|---|---|---|---|---|---|---|---|---|---|---|
| | | | 1 | 2 | 3 | 4 | 1 | 2 | 3 | 4 |
| A | EPA-1 | | 30 | 20 | 20 | 30 | 40 | - | - | 50 |
| B | UX-4101 | | 20 | - | 30 | 20 | - | 35 | 35 | - |
| | UX-2301 | | - | - | - | 10 | - | - | - | - |
| | M-1200 | | - | 20 | - | - 2 | | - | - | - |
| E | | M-315 | - | 20 | - | - | 10 | - | | - |
| | C | R-561 | - | - | - | - 3 | - | 49 | - | 30 |
| | | FA-513A | 50 | - | - | - | - | - | - | - |
| | | TC-101 | - | 40 | 20 | 20 | 40 | - | - | - |
| | D | HEMA | - | - | 10 | 20 | 10 | - | 20 | - |
| | | PM-2 | - | - | - | - | - | - | - | 10 |
| | MANDA | | - | - | 20 | -- | | - | 25 | - |
| | HDDA | | - | - | - | - | | 25 | 20 | 20 |
| F | DETX | | - | 5 | - | -- | - | - | - | - |
| | Irg-184 | | 3 | - | 5 | - | | 7 | - | 5 |
| | Irg-1800 | | 3 | - | 2 | 1 | - | - | - | - |
| | TPO | | - | - | - | - | 5 | - | 5 | 5 |
| | DMBI | | - | 3 | - | - | - | - | - | - |
| Substrate/ Substrate | | | Adhesiveness | | | | | | | |
| (1)/(3) | | | ○ | ○ | ○ | ○ | ○ | × | × | ○ |
| (2)/(3) | | | ○ | ○ | ○ | ○ | ○ | × | Δ | ○ |
| (3)/(3) | | | ○ | ○ | ○ | ○ | × | ○ | Δ | x |
| (1)/(2) | | | ○ | ○ | ○ | ○ | Δ | x | x | Δ |

○: The sputter film or the gold thin film was completely peeled from the polycarbonate plate (substrate) and in the peeling, breakage of substrate was caused or the polycarbonate plate was broken.
Δ: The sputter film or the gold thin film was partly peeled from the polycarbonate plate, and a wrinkle-like crack was caused on the peeling surface or a wrinkle-like crack was caused on the peeling surface of the polycarbonate plate.
×: The sputter film or the gold thin film remained on the polycarbonate plate, or the polycarbonate plates were simply peeled from each other.

As is clear from Table 1, the compositions in Examples 1 to 5 are good in adhesiveness as compared with the adhesives in Comparative Examples 1 to 4, and in use for a single sided read system laminate optical disc in which an information-recording layer has been laminated, a representative of which is DVD, the compositions are useful as ultraviolet-curable adhesives suitable for bonding the resin substrates (3) of a polycarbonate or the like to each other, the metal-sputter-treated substrates (2) to each other and the translucent film-treated substrates (1) to each other.

The ultraviolet-curable adhesive composition of this invention, in a laminate type optical disc such as DVD or the like, is cured with an ultraviolet ray in the bonding of the translucent film-treated substrates (1) provided with a thin film of gold, silver, silicon, a silicon compound or the like, the substrates (2) treated with a metal-sputter film such as aluminum or the like and the resin substrates (3) of a polycarbonate or the like to each other, whereby the properties as an optical disc are kept, so that the composition is good in balance and is such an adhesive that the above three substrates (1) to (3) can keep a sufficient bonding strength, and hence, is very useful from the viewpoint of adhesiveness, protection and productivity of a laminate optical disc, particularly a DVD-ROM in which the translucent film-treated substrate and the metal-sputter film-treated substrate have been laminated.

## Claims

1. An ultraviolet-curable adhesive composition which comprises (A) a bisphenol type epoxy (meth)acrylate having a molecular weight of 450 to 3,000, (B) a urethane (meth)acrylate having a molecular weight of 400 to 10,000, (E) a (meth)acrylate monomer other than (A) and (B), and (F) one or more photopolymerization initiator(s) selected from the group consisting of 1-hydroxycyclohexyl phenyl ketone, (1-6-η-cumene)(η- cyclopenta-dienyl)iron (1 +) hexafluorophosphoric acid (1-), 2,2-dimethoxy-2-phenylacetophenone, 2-methyl-[4-(methylthio)-phenyl]-2-morpholino-1-propanone, 2-chlorothioxanthone, 2,4-dimethylthioxanthone, 2,4-diethylthioxanthone, 2,4-diisopropyl-thioxanthone, isopropyl-thioxanthone, 2,4,6-trimethylbenzoyldiphenylphosphine oxide and bis(2,6-dimethoxybenzoyl)-2,4,4-trimethylpentylphosphine oxide.

2. The ultraviolet-curable adhesive composition according to Claim 1, wherein the urethane (meth)acrylate (B) has a polyester structure, a polyether structure or a polycarbonate structure.

3. The ultraviolet-curable adhesive composition according to Claim 1 which comprises (C) a (meth)acrylate monomer having a cyclic structure as the (meth)acrylate monomer (E) other than (A) and (B).

4. The ultraviolet-curable adhesive composition according to Claim 1 which comprises (C) a (meth)acrylate monomer having a cyclic structure and (D) an aliphatic (meth)acrylate monomer having a hydroxyl group as the (meth)acrylate monomer (E) other than (A) and (B).

5. The ultraviolet-curable adhesive composition according to Claim 1, wherein as the nonvolatile matter in the ultraviolet-curable adhesive, the bisphenol type epoxy (meth)acrylate (A) having a molecular weight of 450 to 3,000 is contained 5 to 70% by weight, the urethane (meth)acrylate (B) having a molecular weight of 400 to 10,000 is contained 5 to 60% by weight, the (meth)acrylate monomer (E) other than (A) and (B) is contained 10 to 80% by weight, and the photopolymerization initiator (F) is contained 0.01 to 20% by weight.

6. The ultraviolet-curable adhesive composition according to Claim 5, wherein the (meth)acrylate monomer (E) other than (A) and (B) is composed of 100 to 30% by weight of (C) a (meth)acrylate monomer having a cyclic structure, 0 to 70% by weight of (D) an aliphatic (meth)acrylate monomer having a hydroxyl group and 0 to 20% by weight of a (meth)acrylate monomer other than (C) and (D).

7. The ultraviolet-curable adhesive composition according to Claim 5, wherein the (meth)acrylate monomer (E) other than (A) and (B) is composed of 95 to 30% by weight of (C) a (meth)acrylate monomer having a cyclic structure, 5 to 70% by weight of (D) an aliphatic (meth)acrylate monomer having a hydroxyl group and 0 to 20% by weight of a (meth)acrylate monomer other than (C) and (D).

8. An article having a layer composed of a cured product of the ultraviolet-curable adhesive composition according to any one of Claims 1 to 7.

9. The article according to Claim 8 which is an optical disc.

10. The article according to Claim 9, wherein the optical disc is DVD.

11. The article according to Claim 10, wherein the DVD is a single sided read system double layer type DVD.

## Patentansprüche

1. Eine durch ultraviolettes Licht härtbare Klebstoff-Zusammensetzung, enthaltend
(A) ein Epoxy-(meth)acrylat des Bisphenol-Typs mit einem Molekulargewicht von 450 bis 3.000,
(B) ein Urethan-(meth) acrylat mit einem Molekulargewicht von 400 bis 10.000,
(E) ein (Meth)acrylat-Monomer, das sich von (A) und (B) unterscheidet, und
(F) einen oder mehrere Photopolymerisations-Initiatoren, ausgewählt aus der Gruppe bestehend aus 1-Hydroxycyclohexylphenylketon, (1-6-η-Cumol)(η-cyclopentadienyl)-eisen(1+)hexafluorophosphorsäure(1 -), 2,2-Dimethoxy-2-phenylacetophenon, 2-Methyl-[4-(methylthio)phenyl]-2-morpholino-1-propanon, 2-Chlorothioxanthon, 2,4-Dimethylthioxanthon, 2,4-Diethylthioxanthon, 2,4-Diisopropylthioxanthon, Isopropylthioxanthon, 2,4,6-Trimethylbenzoyldiphenylphosphinoxid, und bis(2,6-Dimethoxybenzoyl)-2,4,4-trimethylpentylphosphinoxid.

2. Die durch ultraviolettes Licht härtbare Klebstoff-Zusammensetzung gemäß Anspruch 1 , wobei das Urethan-(Meth)acrylat (B) eine Polyesterstruktur, eine Polyetherstruktur oder eine Polycarbonatstruktur hat.

3. Die durch ultraviolettes Licht härtbare Klebstoff-Zusammensetzung gemäß Anspruch 1, umfassend (C) ein (Meth)acrylat-Monomer mit einer zyklischen Struktur als (Meth)acrylat-Monomer (E), das sich von (A) und (B) unterscheidet.

4. Die durch ultraviolettes Licht härtbare Klebstoff-Zusammensetzung gemäß Anspruch 1 umfassend (C) ein (Meth)acrylat-Monomer mit einer zyklischen Struktur und (D) ein aliphatisches (Meth)acrylat-Monomer mit einer Hydroxygruppe als (Meth)acrylat-Monomer (E), das sich von (A) und (B) unterscheidet.

5. Die durch ultraviolettes Licht härtbare Klebstoff-Zusammensetzung gemäß Anspruch 1, in welcher als nichtflüchtige Substanz in dem durch ultraviolettes Licht härtbaren Klebstoff ein Epoxy-(meth)acrylat (A) des Bisphenol-Typs mit einem Molekulargewicht von 450 bis 3.000 zu 5 bis 70 Gew.-%, enthalten ist, das Urethan-(meth)acrylat (B) mit einem Molekulargewicht von 400 bis 10.000 zu 5 bis 60 Gew.-% enthalten ist, das (Meth)acrylat-Monomer (E), das sich von (A) und (B) unterscheidet, zu 10 bis 80 Gew.-% enthalten ist, und der Photopolymerisations-Initiator (F) zu 0,01 bis 20 Gew.-% enthalten ist.

6. Die durch ultraviolettes Licht härtbare Klebstoff-Zusammensetzung gemäß Anspruch 5, in welcher das (Meth)acrylat-Monomer (E), das sich von (A) und (B) unterscheidet, zu 100 bis 30 Gew.-% aus (C) einem (Meth)acrylat-Monomer mit einer zyklischen Struktur, zu 0 bis 70 Gew.-% aus (D) einem aliphatischen (Meth)acrylat-Monomer mit einer Hydroxygruppe und zu 0 bis 20 Gew.-% aus einem (Meth)acrylat-Monomer, das sich von (C) und (D) unterscheidet, zusammengesetzt ist.

7. Die durch ultraviolettes Licht härtbare Klebstoff-Zusammensetzung gemäß Anspruch 5, in welcher das (Meth)acrylat-Monomer (E), das sich von (A) und (B) unterscheidet, zu 95 bis 30 Gew.-% aus (C) einem (Meth)acrylat-Monomer mit einer zyklischen Struktur, zu 5 bis 70 Gew.-% aus (D) einem aliphatischen (Meth)acrylat-Monomer mit einer Hydroxygruppe und zu 0 bis 20 Gew.-% aus einem (Meth)acrylat-Monomer, das sich von (C) und (D) unterscheidet, zusammengesetzt ist.

8. Ein Gegenstand mit einer Schicht, die aus einem gehärteten Produkt aus der durch ultraviolettes Licht härtbaren Klebstoff-Zusammensetzung gemäß einem der Ansprüche 1 bis 7 aufgebaut ist.

9. Der Gegenstand gemäß Anspruch 8, wobei dieser eine optische Disk ist.

10. Der Gegenstand gemäß Anspruch 9, wobei die optische Disk eine DVD ist.

11. Der Gegenstand gemäß Anspruch 10, wobei die DVD eine einseitig lesbare zweischichtige DVD ist.

## Revendications

1. Composition adhésive réticulable aux ultraviolets qui comprend (A) un (méth)acrylate d'époxyde de type bisphénol possédant un poids moléculaire de 450 à 3 000, (B) un (méth)acrylate d'uréthane possédant un poids moléculaire de 400 à 10 000, (E) un monomère (méth)acrylate autre que (A) et (B), et (F) un ou plusieurs initiateur(s) de photopolymérisation choisi dans le groupe consistant en 1-hydroxycyclohexyl phényl cétone, (1-6-η-cumène)(η-cyclopenta-diényl)fer (1+) acide hexafluorophosphorique (1-), 2,2-diméthoxy-2-phénylacétophénone, 2-méthyl-[4-(méthylthio)-phényl]-2-morpholino-1-propanone, 2-chlorothioxanthone, 2,4-diméthylthioxanthone, 2,4-diéthylthioxanthone, 2,4-diisopropylthioxanthone, isopropyl-thioxanthone, oxyde de 2,4,6-triméthylbenzoyldiphénylphosphine et oxyde de bis(2,6-diméthoxybenzoyl)-2,4,4-triméthylpentylphosphine.

2. Composition adhésive réticulable aux ultraviolets selon la revendication 1, dans laquelle le (méth)acrylate d'uréthane (B) possède une structure polyester, une structure polyéther ou une structure polycarbonate.

3. Composition adhésive réticulable aux ultraviolets selon la revendication 1, qui comprend (C) un monomère (méth)acrylate possédant une structure cyclique en tant que monomère (méth)acrylate (E) autre que (A) et (B).

4. Composition adhésive réticulable aux ultraviolets selon la revendication 1, qui comprend (C) un monomère (méth)acrylate possédant une structure cyclique et (D) un monomère (méth)acrylate aliphatique possédant un groupe hydroxy en tant que monomère (méth)acrylate (E) autre que (A) et (B).

5. Composition adhésive réticulable aux ultraviolets selon la revendication 1, dans laquelle en tant que composé non volatil dans l'adhésif réticulable aux ultraviolets, le (méth)acrylate d'époxyde de type bisphénol (A) possédant un poids moléculaire de 450 à 3 000 représente 5 à 70% en poids, le (méth)acrylate d'uréthane (B) possédant un poids moléculaire de 400 à 10 000 représente 5 à 60% en poids, le monomère (méth)acrylate (E) autre que (A) et (B) représente 10 à 80% en poids, et l'initiateur de photopolymérisation (F) représente 0,01 à 20% en poids.

6. Composition adhésive réticulable aux ultraviolets selon la revendication 5, dans laquelle le monomère (méth)acrylate (E) autre que (A) et (B) est composé de 100 à 30% en poids de (C) un monomère (méth)acrylate possédant une structure cyclique, 0 à 70% en poids de (D) un monomère (méth)acrylate aliphatique possédant un groupe hydroxy et 0 à 20% en poids d'un monomère (méth)acrylate autre que (C) et (D).

7. Composition adhésive réticulable aux ultraviolets selon la revendication 5, dans laquelle le monomère (méth)acrylate (E) autre que (A) et (B) est composé de 95 à 30% en poids de (C) un monomère (méth)acrylate possédant une structure cyclique, 5 à 70% en poids de (D) un monomère (méth)acrylate aliphatique possédant un groupe hydroxy et 0 à 20% en poids d'un monomère (méth)acrylate autre que (C) et (D).

8. Article possédant une couche composée d'un produit réticulé de la composition adhésive réticulable aux ultraviolets selon l'une quelconque des revendications 1 à 7.

9. Article selon la revendication 8 qui est un disque optique.

10. Article selon la revendication 9, dans lequel le disque optique est un DVD.

11. Article selon la revendication 10, dans lequel le DVD est un DVD de type bicouche à système de lecture monoface.
